# EUROPÄISCHE PATENTSCHRIFT

(11) **EP 2 273 181 B1**
(45) Veröffentlichungstag und Bekanntmachung des Hinweises auf die Patenterteilung: **07.05.2014**
(21) Anmeldenummer: 10168269.8
(22) Anmeldetag: 02.07.2010
(51) Int. Cl.: F21V 29/00, F21K 99/00, H05K 1/05, F21Y 101/02, F21W 131/10, H05K 3/14

(54) **Außen- oder Innenraumleuchte**
Indoor or outdoor luminaire
Luminaire d'intérieur ou d'exterieur

(30) Priorität: 07.07.2009 DE 102009032094
(43) Veröffentlichungstag der Anmeldung: 12.01.2011
(73) Patentinhaber: Siteco Beleuchtungstechnik GmbH, 83301 Traunreut (DE)
(72) Erfinder: Metzeroth, Stefan, 83250, Marquartstein (DE); Meyer, Clemens, 83278, Traunstein (DE); Härtl, Michael, 83278, Traunstein (DE)
(74) Vertreter: Schmidt, Steffen

(56) Entgegenhaltungen:
- EP-A1- 0 545 230
- EP-A1- 0 555 667
- EP-A1- 1 890 340
- DE-A1-102006 033 873
- DE-B3-102004 056 492
- GB-A- 1 265 007
- JP-A- 2004 179 224
- US-A- 3 922 386
- US-A1- 2008 257 585
- Clyde F. Coombs: "Vapor-Phase Reflow Soldering" In: "Printed Circuits Handbook (Sixth Edition)", 29 August 2007 (2007-08-29), McGraw-Hill Professional, XP055071693, ISBN: 0071467343 pages 47.42-47.43, * paragraph [47.6.3] *

## Beschreibung

Die vorliegende Erfindung betrifft ein thermisch leitfähiges Trägerelement mit keramischer Isolationsschicht zur Anwendung für LEDs (lichtemittierende Dioden).

Die fortschreitende Entwicklung im Bereich der LED-Technik ermöglicht immer lichtstärkere LEDs. Durch die Verwendung lichtstarker LED-Bauelemente lassen sich sowohl Innen- als auch Außenleuchten realisieren, die auf LEDs als Leuchtmittel beruhen. Die einzelnen LEDs sind hierbei in der Regel auf einem Trägerelement angeordnet. Durch die hohe Leistungsfähigkeit der LEDs entsteht oft auch eine hohe Verlustleistung. Diese kann eine Überhitzung der LEDs bewirken, welche zu einer Degradation der Bauelementeigenschaften, zu einer vorzeitigen Alterung oder zu einem frühen Ausfall des LEDs führen kann. Um dies zu vermeiden, ist eine wirksame Kühlung der LEDs erforderlich. Hierbei ist es von technischem Vorteil, wenn die Kühlung über das Trägerelement selbst geschieht, um zusätzlichen Aufwand und damit verbundene Kosten zu reduzieren. Diese zusätzliche Anforderung an das Trägerelement ist jedoch mit weiteren Erfordernissen, wie z.B. der elektrischen Isolation in Einklang zu bringen.

Aus dem Stand der Technik sind Kühlkörper bekannt, die vollständig aus Keramik bestehen, und auf welchen elektrische Bauelemente direkt aufgebracht werden können. Derartige Kühlkörper realisieren die erforderliche elektrische Isolation der elektrischen Schaltung zu ihrer Umgebung. Durch den hohen Wärmewiderstand der verwendeten keramischen Materialien kommt es jedoch im Vergleich zu metallischen Kühlkörpern zu einer weniger ausgeprägten Kühlung der Bauelemente.

Diesen Nachteil vermeidet der in DE 10 2007 064 075 A1 offenbarte Stand der Technik. Dort wird ein Schaltungsträger aus Aluminium offenbart, dessen Oberfläche mittels anodischer Oxidation im sogenannten Eloxal-Verfahren oxidiert ist. Mittels der Oxidschicht wird eine elektrische Isolation zwischen dem metallischen Bereich des Schaltungsträgers und den auf gedruckten Schaltkreisen hergestellt. Durch den geringen Wärmewiderstand von Aluminium lässt sich hierdurch ein wesentlicher Kühlungseffekt realisieren. Die Verwendung einer derartigen mittels anodischer Oxidation erzeugten Oxidschicht zur elektrischen Isolation zeigt Jedoch den Nachteil, dass die resultierende Schicht eine hohe Porosität aufweist. Durch die Poren können im Betrieb elektrische Überschläge von den Schaltkreisen auf den metallischen Bereich des Schaltungsträger entstehen. Werden die Poren hingegen beispielsweise durch eine Imprägnierung verschlossen, verringert sich in der Regel die Haftfestigkeit der aufgebrachten Schaltkreise auf der Oxidschicht. Darüber hinaus sind die mit diesem Verfahren hergestellten Schichten üblicherweise weniger als etwa 25 µm dick.

US 2008/0257585 A1 offenbart ein Substrat, insbesondere aus Aluminium, welches durch eine plasmaclektrolytische Oxydation mit einer Keramik beschichtet wird. Die Keramikschicht weist eine dichtere Schicht am Substrat und eine dünnere poröse äußere Schicht auf. Mittels einer Klebeschicht aus Glas wird eine metallische Folie auf der Außenseite angebracht. Über der metallischen Folie ist eine weitere Klebeschicht und eine Polymerträgerschicht vorgesehen. Auf der Außenseite dieser Schichten können LEDs vorgesehen sein, welche durch Löcher in der Polymerträgerschicht mit der metallischen Folie verbunden sind. Ferner sind Leuchtenanordnungen offenbart, bei welcher das metallische Substrat als Kühlkörper ausgebildet ist.

DE 10 2006 033 837 A offenbart eine strahlungsemittierende Einrichtung mit mehreren strahlungsemittierenden Bauelementen, welche in unterschiedlichen Richtungen auf Oberflächenabschnitten eines Substrats angeordnet sind. Das Substrat ist durch Eloxieren der Oberfläche mit einer elektrisch isolierenden Schicht, vorzugsweise Aluminiumoxid beschichtet. Darüber sind elektrische Zuleitungen vorgesehen, die vorzugsweise durch einen Lithographieprozess aufgebracht werden.

Aufgabe der vorliegenden Erfindung ist es, eine Leuchte bereitzustellen, die eine einfache Fertigung und Montage ermöglicht.

Dic Erfindung löst die Aufgabe durch das Bereitstellen der Außen- oder Innenraumleuchte nach Anspruch 1. Bevorzugte Ausführungsformen sind Gegenstände der Unteransprüche.

Das Trägerelement umfasst einen metallischen Kern, welcher zumindest in einem Teilbereich seiner Oberfläche mit einer Oxidkeramikschicht versehen ist. Die Oxidkeramikschicht weist dabei eine Porosität auf, welche von der Grenzfläche zwischen dem metallischen Kern und der Oxidkeramikschicht in Richtung der Oberfläche der Oxidkeramikschicht zunimmt. Durch die geringe Porosität nahe der Grenzfläche zum metallischen Kern wird eine hohe Festigkeit gegenüber elektrischen Überschlägen erreicht. Zusätzlich bewirkt die erhöhte Porosität an der Oberfläche der Oxidkeramikschicht eine gute Haftfestigkeit für aufgebrachte Leiterbahnen und LEDs oder sonstige elektrische oder elektronische Bauelemente (z.B. Chips zur LED-Steuerung). Unter LEDs sind auch OLEDs zu verstehen. Diese eignen sich besonders zur flächigen Auftragung.

Zur Herstellung der isolierenden Oxidkeramikschicht kann gemäß einer Ausführungsform der Erfindung ein plasmachemisches Verfahren unter Funkenentladung verwendet werden. Bei diesem Verfahren wird in einem Elektrolyten unter Plasmabedingungen eine Oxidkeramikschicht auf der Metalloberfläche erzeugt. Der metallische Kern ist dabei als Elektrode im Elektrolyten angeordnet. Durch das Anlegen einer hinreichend hohen Spannung kommt es zu Funkenentladung an der Oberfläche des Metalls. Hierdurch wird ein Sauerstoffplasma er-durch das sich die Oxidkeramikschicht bildet. Die Metallionen in der Oxidkeramikschicht stammen dabei aus dem metallischen Kern, der Sauerstoff aus dem verwendeten Elektrolyten. Während dieses Vorgangs kommt es zu einem Aufschmelzen der Oxidkeramik. Die Schmelze wird jedoch rasch auf der Seite zum Elektrolyten hin durch diesen abgekühlt, wobei die abwandernden Gase, insbesondere Sauerstoff und Wasserdampf in der Oxidkeramikschicht ein weitmaschig verknüpftes Kapillarsystem hinterlassen. Im Ergebnis weist die Oxidkeramikschicht eine Porosität auf, welche in Richtung vom metallischen Kern zur Oberfläche hin zunimmt.

Gemäß einer Ausführungsform der Erfindung beträgt die Porengröße an der Grenzfläche zum metallischen Kern 0,7 µm und weniger und die Porengröße an der Oberfläche der Oxidkeramikschicht beträgt 1,3 µm und mehr. Es sind auch deutlich kleinere Poren von weniger als 0,1 µm Durchmesser an der Grenzfläche zum metallischen Kern und größere Poren von mehr als 30 µm Durchmesser an der Oberfläche möglich.

Gemäß einer Ausführungsform umfasst der metallische Kern des Trägerelements ein Metall mit einer Wärmeleitfähigkeit von mehr als 40 W/(mK). In einer bevorzugten Ausführungsform ist das Material Aluminium. Durch die gute Wärmeleitfähigkeit von Aluminium, die typischerweise etwa 210 W/(mK) beträgt, wird eine besonders gute thermische Leitfähigkeit des Trägerelements erreicht. Des Weiteren stellt Aluminium ein relativ kostengünstiges Material dar, das sich überdies durch eine geringe Dichte und ein dadurch erreichtes geringes Gewicht der Gesamtanordnung auszeichnet. Darüber hinaus wird durch die Anwendung des beschriebenen Verfahrens auf Aluminium eine Aluminiumoxidschicht erzeugt, welche auch Korund umfassen kann, und welche besonders vorteilhafte technische Eigenschaften aufweist. So liegt die thermische Leitfähigkeit des erzeugten Aluminiumoxids typischerweise über etwa 10 W/(mK), insbesondere bei etwa 30 W/(mK). Diese hohe thermische Leitfähigkeit der Oxidkeramikschicht bedingt eine besonders effiziente Abfuhr der in den LEDs entstehenden Verlustwärme. Darüber hinaus weist Aluminiumoxid eine besonders gute elektrische Isolationsfähigkeit auf. Gemäß Ausführungsformen der Erfindung beträgt die spezifische elektrische Leitfähigkeit der als Isolator wirkenden Oxidkeramikschicht weniger als 10⁻¹⁴ Ω⁻¹m⁻¹ bei Raumtemperatur. In weiteren Ausführungsformen umfasst das Trägerelement ein anderes Metall, auf dem eine Oxidkeramikschicht mittels eines plasmachemischen Verfahrens hergestellt werden kann, wie z.B. Titan, Tantal, Zirkonium, Niob, Haffnium, Antimon, Wolfram, Molybdän, Vanadium, Wismut oder Magnesium. Erfindungsgemäß ist auch die Verwendung einer Legierung möglich, die eines der genannten Metalle umfasst.

Erfindungsgemäß sind elektrische Leiterbahnen und/oder elektrische Bauelemente direkt auf der Oxidschicht aufgebracht. Hierbei ist von Vorteil, dass die erfindungsgemäß hergestellte oberflächennahe porenreiche Oxidkeramikschicht ein gutes Haftvermögen aufweist. Auf diese Weise kann ein zusätzlicher Montageschritt, wie er bei der Verwendung einer zusätzlichen Platine nötig wäre, vermieden werden. Des Weiteren ergibt sich durch den Verzicht auf eine weitere Zwischenschicht zur Anordnung der Leiterbahnen eine erhöhte Zuverlässigkeit und eine bessere thermische Ankopplung der Bauelemente.

Gemäß einer Ausführungsform beträgt die Dicke der Oxidkeramikschicht zwischen etwa 5 µm und etwa 400 µm, insbesondere zwischen etwa 25 µm und 200 µm, besonders bevorzugt zwischen etwa 40 µm und etwa 160 µm. Die mittels herkömmlicher anodischer Oxidation im sogenannten Eloxal-Verfahren hergestellten Schichten haben typischerweise eine Dicke von weniger als etwa 25 µm. Durch die erfindungsgemäße Verwendung eines plasmachemischen Verfahrens unter Funkenentladung lassen sich hingegen auch deutlich dickere Schichten herstellen. Derart hohe Schichtdicken bewirken eine erhöhte Festigkeit gegenüber elektrischen Durchschlägen sowie eine erhöhte Festigkeit gegenüber Korrosion, mechanischem Abrieb und Kratzern. Alternativ lässt sich die Oxidkeramikschicht nach der vorliegenden Erfindung auch durch thermisches Spritzen aufbringen. In einer weiteren Ausführungsform kann die Oxidkeramikschicht auch durch Drucken aufgebracht werden.

Gemäß einer bevorzugten Ausführungsform dient darüber hinaus der metallische Kern des Trägerelements als Kühlkörper. Hierzu kann der metallische Kern in Teilbereichen seiner Oberfläche, welche nicht mit Leiterbahnen und LEDs versehen sind, oberflächenvergrößernde Strukturen aufweisen. Bevorzugt sind dabei rippenartig oder linsenförmig ausgebildete Oberflächenprofile. Insbesondere im Zusammenwirken mit der Verwendung von Aluminium als Material für dem metallischen Kern ergibt sich ein Vorteil, den metallischen Kern des Trägerelements gleichzeitig als Kühlkörper einzusetzen. Die hohe Wärmeleitfähigkeit von Aluminium trägt dazu bei, die in den LEDs erzeugte Verlustwärme effizient von den LEDs abzuführen. Durch die Ausbildung des Trägerelements als Kühlkörper kann in einigen Ausführungsrungsformen darüber hinaus auf die Verwendung eines weiteren, separaten Kühlkörpers verzichtet werden.

Der metallische Kern ist auf Teilbereichen seiner Oberfläche mit der Oxidkeramikschicht besetzt. Nach einer Ausführungsform ist die vollständige Oberfläche des Kerns mit der Oxidkeramikschicht überzogen.

Das LED-Trägerelement wird für eine Außen- oder Innenraumleuchte verwendet. Insbesondere kann in einigen Ausführungsformen die mit LEDs besetzte Oberfläche des Trägerelements in Teilbereichen eine Oberfläche einer Leuchte bilden. Das Trägerelement ist in Teilbereichen seiner Oberfläche mit Mitteln versehen, welche zur Befestigung der Leuchte an einem Leuchtenträger, wie z.B. einem Mast oder einer Schiene, dienen. Hierzu kann das Trägerelement z.B. mit einer Öse, einer Eintiefung, einem Vorsprung oder einem Gewinde versehen sein. Das Trägerelement ist so ausgebildet, dass eine wenigstens teilweise transparente Abdeckung an ihr angebracht werden kann, welche als Lichtaustrittsmittel dient. Das Trägerelement und die transparente Abdeckung sind dabei Komponenten eines Leuchtengehäuses. Insbesondere bietet eine solche Anordnung den Vorteil, dass die LEDs vor Umwelteinflüssen wie z.B. Staub oder Feuchtigkeit geschützt werden. Dies ist neben der Verwendung als Innenraumleuchte insbesondere für Außenleuchten vorteilhaft. Ähnliche Vorrichtungen wie zur Befestigung an einem Leuchtenträger können an dem Trägerelement auch zur Befestigung der wenigstens teilweise transparenten Abdeckung und/oder zur Befestigung von Optiken, oder Reflektoren zur Lichflenkung des Lichts der LEDs vorgesehen sein.

Die Erfindung kann weiterhin vorsehen, dass das Trägerelement auf einem Küblkörper angeordnet ist, mit welchem es sich in thermischem Kontakt befindet, oder den Kühlkörper selbst bildet. Der Kühlkörper kann dabei insbesondere ein metallisches Material wie z.B. Aluminium oder Kupfer umfassen. Der thermische Kontakt zwischen dem Trägerelement und dem Kühlkörper kann ferner durch die Verwendung eines thermisch leitfähigen Materials, insbesondere einer Wärmeleitpaste, verbessert werden. Insgesamt ergibt sich durch die Verwendung eines Kühlkörpers eine verbesserte Wärmeabfuhr. Durch die Verwendung eines weiteren thermisch leitfähigen Materials, wie z.B. einer Wärmeleitpaste, wird ein zusätzlicher Wärmewiderstand für den Übergang der Wärme von dem Trägerelement auf den Kühlkörper gering gehalten.

Gemäß einer weiteren Ausführungsform weist die Oxidkeramikschicht in Teilbereichen eine nicht-ebene Oberfläche auf. Insbesondere durch die Verwendung eines gekrümmten metallischen Kerns lässt sich mittels eines plasmachemischen Verfahrens unter Funkenentladung eine große Auswahl an gekrümmten Oberflächen herstellen. Hierbei lässt sich durch eine gekrümmte Oberfläche des Trägerelements die Abstrahlchalrakteristik einer Leuchte einstellen. Durch die Verwendung einer gekrümmten Oberfläche lassen sich dabei LEDs auf eine gewünschte Art räumlich ausrichten. Die Lichtverteilung der Leuchte kann hierdurch für bestimmte Anwendungen optimiert werden. Beispielsweise kann in einer Ausführungsform, in welcher das Trägerelement für ein LED-Modul im Bereich der Straßenbeleuchtung verwendet wird, durch die Verwendung eines Trägerelements mit gekrümmter Oberfläche eine Lichtverteilung eingestellt werden, welche eine gleichmäßige Ausleuchtung des Straßenvertaufs erzielt, und dabei störende Blendeffekte sowie eine übermäßige Beleuchtung eines Bereichs abseits der Straße vermeidet.

Auf der Oberfläche des Trägerelements sind auch andere elektronische Bauelemente als LEDs angeordnet. So sind neben den LEDs auch elektronische Bauelemente zu deren Ansteuerung auf dem Trägerelement angeordnet. Ferner können auf dem Trägerelement auch Sensoren, wie insbesondere Temperatursensoren angeordnet sein.

Weitere Merkmale und Vorteile der Erfindung ergeben sich aus der nachfolgenden Beschreibung eines bevorzugten Ausfübrungsbeispiels der Erfindung anhand der beigefügten Zeichnungen.

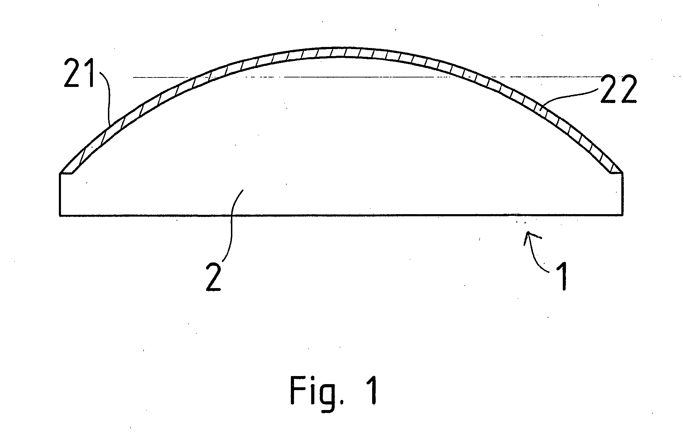

- Figur 1: zeigt eine Teilansicht eines erfindungsgemäßen Trägerelements im Querschnitt, die eine keramische Isolationsschicht aufweist,
- Figur 2: zeigt eine Teilansicht eines erfindungsgemäßen Trägerelements mit aufgebrachten Leiterbahnen und LED im Queirschnitt.
- Figur 3: zeigt eine vergrößerte Teilansicht einer erfindungsgemäßen Oxidkeramik- schicht im Querschnitt.

Die Figuren zeigen den erfindungsgemäßen Aufbau des Trägerelements. Das Trägerelement 1 weist dabei einen metallischen Kern 2 auf. Ein Teilbereich 21 der Oberfläche des metallischen Kerns 2 ist mit einer Oxidkeramikschicht 22 versehen.

Die Oxidkeramikschicht 22 wird auf dem metallischen Kern 2 erzeugt, indem dieser in dem Teilbereich 21 seiner Oberfläche mittels eines plasmachemischen Verfahrens unter Funkenentladungen oxidiert wird. Dies geschieht insbesondere durch anodische Oxidation in einem wässrigen Elektrolyten, wobei unter Plasmabedingungen eine Gas-Festkörper-Reaktion abläuft, bei der durch einen hohen Energieeintrag auf dem metallischen Kern, welcher als Anode geschaltet ist, flüssiges Metall erzeugt wird. Dieses bildet mit aktiviertem Sauerstoff ein kurzzeiterschmolzenes Oxid.

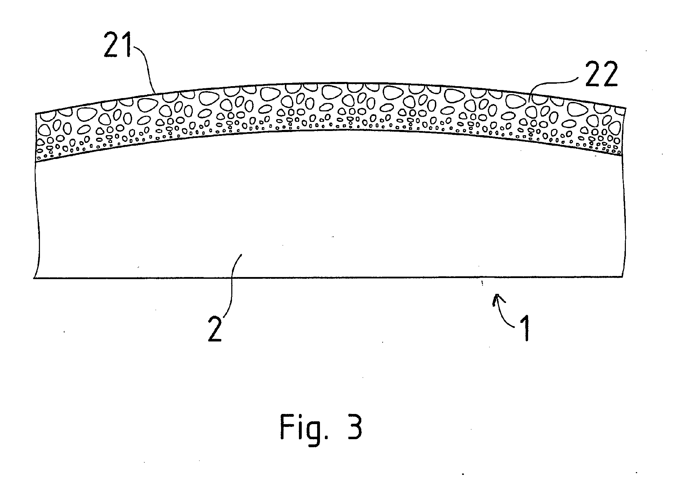

Auf einem Metall wie insbesondere Aluminium befindet sich natürlicherweise eine Sperrschicht. Durch eine Erhöhung der Spannung während dieses Verfahrens wächst die Sperrschicht auf dem metallischen Kern, welcher als Anode gepolt ist. Sodann entsteht an der Phasengrenze Metall/Gas/Elektrolyt ein Sauerstoffplasma, durch welches sich die Oxidkeramikschicht 22 bildet. Hierbei stammt das Metallion in der Oxidkeramikschicht aus dem metallischen Kern 2, während der Sauerstoff aus anodischen Reaktion in dem verwendeten Elektrolyten stammt. Die Oxidkeramik ist bei den eintretenden Plasmabedingungen flüssig. Auf der Seite zum metallischen Kern 2 hin ist die Zeit ausreichend, damit sich die Oxidkeramikschmelze gut zusammenziehen kann und auf diese Weise eine aufgesinterte, porenarme Oxidkeramikschicht 22 bildet. Zu der Seite des Elektrolyten hin wird die Schmelze der Oxidkeramik schnell durch den Elektrolyten abgekühlt und die abwandernden Gase, insbesondere Sauerstoff und Wasserdampf hinterlassen eine Oxidkeramikschicht mit einem weitmaschig verknüpften Kapillarsystem. Durch dieses Verfahren weist die Oxidkeramikschicht 22 ein Porosität auf, welche ausgehend von der dem metallischen Kern 2 zugewandten Seite hin zur Oberfläche der Schicht zunimmt. Dies ist schematisch in Figur 3 gezeigt. Der dem metallischen Kern 2 benachbarte Teil der Oxidkeramikschicht 22 weist durch seine geringe Porosität dabei eine hohe Festigkeit gegenüber elektrischen Entladungen auf. Der dem metallischen Kern 2 abgewandten Seite der Oxidkeramikschicht 22 hingegen ist durch seine hohe Porosität dazu geeignet, ein gutes Haftvermögen für Leiterbahnen bereitzustellen.

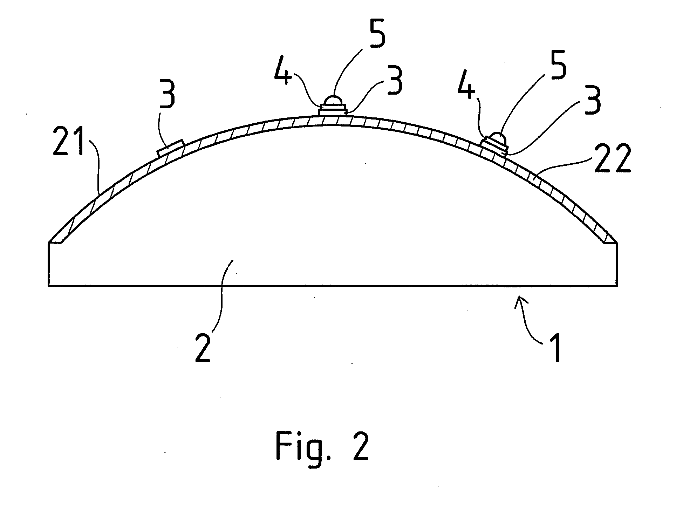

Auf der dem metallischen Kern 2 abgewandten Oberfläche der Oxidkeramikschicht 22 sind, wie in Figur 2 gezeigt, Leiterbahnen 3 sowie LEDs 5 angeordnet. In einer Ausführungsform sind die LEDs 5 mit Hilfe von Sockeln 4 mit den Leiterbahnen 3 kontaktiert. Insbesondere können mehrere LEDs 5 mit Hilfe des gleichen Sockels 4 montiert sein. Ferner können die LEDs 5 alternativ auch ohne Verwendung eines Sockels direkt mit den Leiterbahnen 3 kontaktiert sein. Dies ist insbesondere bei einer hohen Besetzungsdichte der LEDs von Vorteil. Die Leiterbahnen 3 können z.B. Aluminium, Kupfer, Silber oder deren Legierungen umfassen. Insbesondere im Zusammenhang mit der Verwendung von Trägerelementen mit einer gekrümmten Oberfläche stellt sich dabei das Problem, die Leiterbahnen 3 an der Oberfläche der Oxidkeramikschicht 22 anzubringen. Hierbei ist insbesondere ein Druckverfahren wie Tampondruck vorteilhaft, wie es zum Bedrucken von Kunststoffkörpern verwendet wird. Durch die Anwendung dieses Verfahrens ergibt sich ein erheblicher Vorteil gegenüber bekannten Leuchten-Anordnungen, in welchen oft ebene LED-Module in einem Winkel zueinander angeordnet werden, um eine gewünschte Lichtverteilungskurve zu erzeugen. Die separat angeordneten LED-Module werden dabei in der Regel durch eine externe Verkabelung miteinander verbunden. Dies erfordert einen erheblichen Montageaufwand und bedingt auch Zuverlässigkeitsrisiken. Im Gegensatz dazu wird durch die Verwendung eines Trägerelements mit gekrümmter Oberfläche ein Aufbau ermöglicht, bei welchem die LEDs auf eines einzigen Trägerelements angeordnet sind. Ferner kann durch die Anwendung insbesondere des Tampondruckverfahrens eine aufwändige Verkabelung der einzelnen LEDs vermieden werden, indem die Kontaktierung über Leiterbahnen geschieht, die unmittelbar auf der Oberfläche der Oxidkeramikschicht angeordnet sind. Die Vermeidung von Verkabelungen außerhalb des Trägerelements vermindert somit den Montageaufwand und erhöht gleichzeitig die Zuverlässigkeit des Aufbaus. Letztere Wirkung ist insbesondere vorteilhaft für Außenleuchten-LED-Trägerelemente, insbesondere in einer Anwendung zur Verkehrswegebeleuchtung, Signalleuchte, Fassadenbeleuchtung und als Beleuchtung in elektrischen Geräten (z.B. in Bildschirmanzeigen) und Fahrzeugen bei rauen Umweltbedingungen oder für alle Arten von Innen- und Außenleuchten.

Alternativ sind zum Aufbringen der Leiterbahnen Siebdruck-, oder Schablonendruckverfahren möglich. Weiterhin können galvanische Verfahren auf chemischer oder elektrolytischer Basis bzw. PVD (physical vapor deposition) Verfahren verwendet werden. Ferner ist auch die Anwendung eines subtraktiven Verfahrens wie z.B. eines Ätz- oder Laserverfahrens möglich. Gleichfalls können die Leiterbahnen durch eine Kombination dieser Verfahren aufgebracht werden. So kann beispielsweise ein Siebdruckverfahren verwendet werden, um einen Primer aufzubringen, auf dem eine dünne Kupferschicht durch chemisches Galvanisieren aufgebracht wird, die dann durch elektrolytisches Galvanisieren verstärkt werden kann.

Zusätzlich zu den Leiterbahnen 3 sind auf der Oberfläche der Oxidkeramikschicht LEDs 5 angeordnet. Zur Befestigung der LEDs kann dabei ein Löt-, Klebe- oder Bondingverfahren eingesetzt werden. Durch die Verwendung eines thermisch gut leitfähigen Materials für das Trägerelement ergibt sich insbesondere bei der Verwendung eines Löt- oder Bondingverfahrens das Problem, dass die für das Befestigungsverfahren benötigte Wärme schnell durch das Trägerelement abgeführt wird. Daher ist in der Regel eine Einbringung einer höheren Wärmemenge während des Verfahrens erforderlich, um die benötigten Temperaturen zu erreichen. Hierdurch kann es allerdings zu einer thermischen Überlastung der LEDs kommen. Um diesen Nachteil zu vermeiden, ist insbesondere die Verwendung eines Dampfphasen-Lötverfahrens vorteilhaft. Bei diesem Verfahren kann das mit LEDs bestückte und mit einer Lötpaste versehene Trägerelement in einen Behandlungsraum mit heißem Dampf gebracht werden. Der Dampf heizt das Trägerelement auf, lässt die Lötpaste schmelzen und schafft die Lötverbindung zwischen LEDs und Trägerelement. Aufgrund der kurzen Einwirkzeit und des guten Wärmeübergangs des an der Oberfläche des Lötgutes kondensierenden Dampfes wird nur die Oberfläche des Lötguts erwärmt, ohne dass eine größere Wärmemenge in das Lötgut gerät. Die thermische Belastung der temperaturempfindlichen LEDs, die bis zur Zerstörung der LEDs führen kann, wird dadurch verringert.

Der metallische Kern 2 hat dabei die Funktion, eine stabile Unterlage für die LED-Anordnung, sowie ein Medium für einen effektiven Wärmeabfluss von den LEDs bereitzustellen. Die Oxidkeramikschicht 22 hat die Funktion, eine elektrische Isolation zwischen den Leiterbahnen 3 und dem metallischen Kern 2 des Trägerelements bereitzustellen. Die erhöhte Porosität nahe der Oberfläche der Oxidkeramikschicht bewirkt ein gutes Haftvermögen der Leiterbahnen 3 und der LEDs, wodurch eine verbesserte Zuverlässigkeit des Aufbaus, u. a. bezüglich thermischer und mechanischer Spannung ergibt.

Die in den LEDs 5 erzeugte Verlustwärme wird im Wesentlichen durch die Oxidkeramikschicht 22 an den metallischen Kern 2 weitergeleitet. Dieser ist durch seine gute Wärmeleiteigenschaft dazu in der Lage, die Verlustwärme rasch von dem Teil seiner Oberfläche abzuführen, welcher mit den Leiterbahnen 3 und elektrischen Bauelementen bestückt ist.

Zahlreiche Modifikation der dargestellten bevorzugten Ausführungsformen der Erfindung sind möglich, ohne von dem Umfang der Erfindung, wie er in den Ansprüchen angegeben ist, abzuweichen. Insbesondere kann die Krümmung der mit LEDs besetzten Oberfläche des Trägerelements bzw. die Oberflächen der Oxidkeramikschicht unterschiedlich gestaltet sein oder die Oberfläche kann auch eben sein.

Ferner kann der metallische Kern 2 direkt als Kühlkörper ausgebildet sein, indem er beispielsweise auf einer Seite, vorzugsweise der Seite, welche der mit LEDs besetzten Oberfläche gegenüberliegt, mit Kühlrippen oder ähnlichen oberflächenvergrößernden Strukturen versehen ist.

### Bezugszeichenliste:

- 1: Trägerelement
- 2: Metallischer Kern
- 3: Leiterbahnen
- 4: Sockel
- 5: LEDs
- 21: Teilbereich
- 22: Oxidkeramikschicht

## Patentansprüche

1. Außen- oder Innenraumleuchte, wobei neben den LEDs auch elektronische Bauelemente zu deren Ansteuerung auf den Trägerelement angeordnet sind die ein LED-Trägerelement (1) umfasst, wobei das LED-Trägerelement Folgendes umfasst:
einen metallischen Kern (2), der auf zumindest einem Teilbereich seiner Oberfläche (21) eine Oxidkeramikschicht (22) aufweist, wobei die Oxidkeramikschicht (22) eine Porosität aufweist, welche von der Grenzfläche zum metallischen Kern (2) zur Oberfläche des Trägerelements hin zunimmt,
wenigstens eine Leiterbahn (3), die auf einem Teilbereich auf der von dem metallischen Kern (2) abgewandten Seite der Oxidkeramikschicht (22) angeordnet ist, und LEDs (5), die in elektrischem Kontakt mit der Leiterbahn (3) stehen, wobei die Leiterbahn (3) direkt auf der Oxidkeramikschicht aufgebracht ist,
**dadurch gekennzeichnet, dass** das LED-Trägerelement (1) zumindest in Teilbereichen eine äußere Oberfläche der Leuchte bildet, wobei das Trägerelement Mittel zur Befestigung der Leuchte an einem Leuchtenträger umfasst, wobei das Trägerelement so ausgebildet ist, dass eine wenigstens teilweise transparente Abdeckung an ihm angebracht ist, welche als Lichtaustrittsmittel dient, wobei das Trägerelement und die transparente Abdeckung Komponenten eines Leuchtengehäuses sind und, wobei neben den LEDs auch elektronische Bauelemente zu deren Ansteuerung auf dem Trägerelement angeordnet sind.

2. Außen- oder Innenraumleuchte nach Anspruch 1, wobei die Oxidkeramikschicht (22) zwischen etwa 5 µm und etwa 400 µm, insbesondere etwa zwischen 25 µm und etwa 200 µm, besonders bevorzugt zwischen etwa 40 µm und etwa 160 µm, dick ist.

3. Außen- oder Innenraumleuchte nach einem der vorhergehenden Ansprüche, wobei der metallische Kern (2) ein Material umfasst, das ausgewählt ist aus Aluminium, Titan, Tantal, Niob, Zirkonium, Magnesium, Haffnium, Antimon, Wolfram, Molybdän, Vanadium, Wismut und Legierungen, die eines oder mehrere dieser Metalle umfassen.

4. Außen- oder Innenraumleuchte nach einem der vorhergehenden Ansprüche, wobei die Oxidkeramikschicht (22) Aluminiumoxid umfasst, insbesondere Korund.

5. Außen- oder Innenraumleuchte nach einem der vorhergehenden Ansprüche, wobei die Oxidkeramikschicht (22) eine nicht-ebene Oberflächentopologie auf der dem metallischen Kern (2) abgewandten Seite definiert.

6. Außen- oder Innenraumleuchte nach einem der vorhergehenden Ansprüche, wobei das LED-Trägerelement (1) in Teilbereichen eine Oberfläche der Leuchte hinter der transparenten Abdeckung bildet.

## Claims

1. Indoor or outdoor luminaire which comprises a holder element for an LED module (1) wherein the holder element for the LED module comprises the following:
a metal core (2), which on at least one partial area of its surface (21) has an oxide ceramic layer (22), wherein the oxide ceramic layer (22) has a porosity which increases from the boundary area to the metal core (2) to the surface of the holder element,
at least one strip conductor (3), which is arranged on a partial area on the side of the oxide ceramic layer (22) turned away from the metal core (2), and LEDs (5) which are in electrical contact with the strip conductor (3), wherein the strip conductor (3) is disposed directly on the oxide ceramic layer, **characterised in that** the holder element for an LED module (1) forms an outer surface of the luminaire at least in partial areas, wherein the holder element comprises means for securing the luminaire on a luminaire holder, wherein the holder element is made so that an at least partially transparent cover is disposed on it, which serves as a light exit point, wherein the holder element and the transparent cover are components of a luminaire housing, and wherein in addition to the LEDs, electronic modules for their control are arranged on the holder element.

2. Indoor or outdoor luminaire according to claim 1, wherein the oxide ceramic layer (2) is between around 5 µm and around 400 µm, in particular around between 25 µm and around 200 µm, particularly preferably between around 40 µm and around 160 µm thick.

3. Indoor or outdoor luminaire according to one of the previous claims, wherein the metal core (2) cmprises a material, which is selected from aluminium, titanium, tantalum, niobium, zirconium, magnesium, hafnium, antimony, wolfram, molybdenum, vanadium, bismuth and alloys which comprise one or more of these metals.

4. Indoor or outdoor luminaire according to one of the previous claims, wherein the oxide ceramic layer (22) comprises aluminium oxide, in particular corundum.

5. Indoor or outdoor luminaire according to one of the previous claims, wherein the oxide ceramic layer (22) defines a non-even surface topology on the side turned away from the metal core (2).

6. Indoor or outdoor luminaire according to one of the previous claims, wherein in partial areas the holder element of the LED module (1) forms a surface of the luminaire behind the transparent cover.

## Revendications

1. Luminaire d'extérieur ou d'intérieur, qui comprend un élément (1) support de LED, l'élément support de LED comprenant ce qui suit :
un noyau métallique (2), qui sur au moins une zone partielle de sa surface (21) présente une couche de céramique à base d'oxyde (22), la couche de céramique à base d'oxyde (22) présentant une porosité qui augmente de l'interface avec le noyau métallique (2) à la surface de l'élément support,
au moins une piste conductrice (3), qui est disposée sur une zone partielle sur le côté de la couche de céramique à base d'oxyde (22) opposé au noyau métallique (2), et
des LED (5), qui sont en contact électrique avec la piste conductrice (3), la piste conductrice (3) étant directement appliquée sur la couche de céramique à base d'oxyde,
**caractérisé en ce que** l'élément (1) support de LED forme au moins dans des zones partielles une surface extérieure du luminaire, l'élément support comprenant des moyens pour fixer le luminaire à un support de luminaire, l'élément support étant configuré de telle sorte qu'un recouvrement, au moins partiellement transparent, lui sont rapporté, recouvrement qui sert de moyen de sortie de la lumière, l'élément support et le recouvrement transparent étant des composants d'un boîtier de luminaire, et, outre les LED, des composants électriques destinés à leur excitation étant disposés sur l'élément support.

2. Luminaire d'extérieur ou d'intérieur selon la revendication 1, dans lequel la couche de céramique à base d'oxyde 22 a une épaisseur comprise entre environ 5 µm et environ 400 µm, en particulier entre environ 25 µm et environ 200 µm, d'une manière particulièrement préférée entre environ 40 µm et environ 160 µm.

3. Luminaire d'extérieur ou d'intérieur selon l'une des revendications précédentes, dans lequel le noyau métallique (2) comprend un matériau qui est choisi parmi l'aluminium, le titane, le tantale, le niobium, le zirconium, le magnésium, le hafnium, l'antimoine, le tungstène, le molybdène, le vanadium, le bismuth et les alliages qui comprennent un ou plusieurs de ces métaux.

4. Luminaire d'extérieur ou d'intérieur selon l'une des revendications précédentes, dans lequel la couche de céramique à base d'oxyde (22) comprend de l'oxyde d'aluminium, en particulier du corindon.

5. Luminaire d'extérieur ou d'intérieur selon l'une des revendications précédentes, dans lequel la couche de céramique à base d'oxyde (22) définit une topologie superficielle non plane sur le côté opposé au noyau métallique (2).

6. Luminaire d'extérieur ou d'intérieur selon l'une des revendications précédentes, dans lequel l'élément (1) support de LED forme dans des zones partielles une surface du luminaire en arrière du recouvrement transparent.
